(19) **Europäisches Patentamt** / **European Patent Office** / **Office européen des brevets**

(11) **EP 4 709 129 A1**

(12) **EUROPEAN PATENT APPLICATION**

(43) Date of publication:
**11.03.2026 Bulletin 2026/11**

(21) Application number: **25197749.2**

(22) Date of filing: **22.08.2025**

(51) International Patent Classification (IPC):
**H10N 69/00** (2026.01)

(52) Cooperative Patent Classification (CPC):
**H10N 69/00**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH LA MA MD TN**

(30) Priority: **29.08.2024 JP 2024147955**

(71) Applicant: **Fujitsu Limited**
**Kawasaki-shi, Kanagawa 211-8588 (JP)**

(72) Inventors:
• **SHIMANOUCHI, Takeaki**
  **Kawasaki-shi, 211-8588 (JP)**
• **NAKAMURA, Yasunobu**
  **Wako-shi, Saitama, 351-0198 (JP)**

(74) Representative: **Haseltine Lake Kempner LLP**
**Cheapside House**
**138 Cheapside**
**London EC2V 6BJ (GB)**

(54) **QUANTUM BIT DEVICE AND METHOD FOR MANUFACTURING QUANTUM BIT DEVICE**

(57) A quantum bit device includes a first quantum bit substrate (10A) having a first quantum bit (1A) and a first electrode (18A), and a second quantum bit substrate (10B) having a second quantum bit (1B) and a second electrode (18B). The quantum bit device has a third electrode (23B) and a fourth electrode (23B), and has a connection substrate (20) provided to face the first quantum bit substrate and the second quantum bit substrate. The quantum bit device includes a first capacitor (30A) including the first electrode and the third electrode, a second capacitor (30B) including the second electrode and the fourth electrode, and a third capacitor (30C). The first capacitor, the second capacitor, and the third capacitor are provided in series between the first quantum bit and the second quantum bit. The capacitance of the first capacitor and the capacitance of the second capacitor are larger than the capacitance of the third capacitor.

FIG.6

# Description

FIELD

The disclosed technology relates to a quantum bit device and a method for manufacturing the quantum bit device.

BACKGROUND

As a technology related to a quantum bit device, the following technology is known.

Patent Literature 1 describes a device having a structure in which a first quantum bit substrate and a second quantum bit substrate are flip-chip connected by solder bumps on a base substrate having a superconducting wire forming one closed loop.

Patent Literature 2 discloses a configuration in which a plurality of quantum bit chips mounted on one carrier chip are connected by capacitive coupling. A terminal of the quantum bit chip is capacitively coupled to a terminal provided on a facing surface of the carrier chip.

*Related Patent Documents*

Patent Literature 1: WO 2018/212041
Patent Literature 2: Japanese Patent Application Laid-Open (JP-A) No. 2023-69792

As a quantum bit (Qubit) constituting a quantum bit device, one using a transmon is known. The transmon has a configuration in which a superconducting Josephson element and a capacitor are connected in parallel, and performs a quantum operation using nonlinear energy. In a multi-bit quantum bit device, a plurality of quantum bits are connected to each other via a capacitor. As a configuration for realizing further multi-bit scaling, a configuration is considered in which quantum bits provided on each of a plurality of quantum bit substrates are connected via a capacitor. Specifically, a plurality of quantum bit substrates are mounted on a connection substrate, and quantum bits provided on the respective quantum bit substrates are capacitively coupled to each other via wiring formed on the connection substrate. The capacitor between the quantum bits includes a parallel plate electrode type capacitor (hereinafter, referred to as inter-substrate capacitor) formed by making an electrode provided on the quantum bit substrate and an electrode provided on the connection substrate face each other.

The capacitance C of the parallel plate capacitor is generally expressed by the following Formula (1). In Formula (1), $\varepsilon$ is the dielectric constant of the dielectric, S is the electrode area, and d is the inter-electrode distance.

$$C = \varepsilon \cdot S/d \ ...(1)$$

In the inter-substrate capacitor, the capacitance C varies because an electrode area S and an inter-electrode distance d vary due to a difference in alignment deviation and deformation of the bump when the quantum bit substrate is mounted on the connection substrate. When the capacitance C varies, the coupling strength between the quantum bits varies, and the characteristics of the two-qubit gate may become unstable.

SUMMARY

The disclosed technology has been made in view of the above points, and an object thereof is to suppress variation in coupling strength between quantum bits in a quantum bit device in which quantum bits provided in each of a plurality of quantum bit substrates are capacitively coupled to each other via a connection substrate.

A quantum bit device according to the disclosed technology includes a first quantum bit substrate having a first quantum bit and a first electrode, and a second quantum bit substrate having a second quantum bit and a second electrode. The quantum bit device has a third electrode and a fourth electrode, and has a connection substrate provided to face the first quantum bit substrate and the second quantum bit substrate. The quantum bit device includes a first capacitor including the first electrode and the third electrode, a second capacitor including the second electrode and the fourth electrode, and a third capacitor. The first capacitor, the second capacitor, and the third capacitor are provided in series between the first quantum bit and the second quantum bit. A capacitance of the first capacitor and a capacitance of the second capacitor are larger than a capacitance of the third capacitor.

BRIEF DESCRIPTION OF THE DRAWINGS

Fig. 1 is a plan view illustrating an example of a configuration of a quantum bit device according to an embodiment of the disclosed technology;
Fig. 2 is a plan view illustrating an example of a configuration of a first quantum bit substrate according to an embodiment of the disclosed technology;
Fig. 3 is an enlarged view of one of basic units according to an embodiment of the disclosed technology;
Fig. 4 is an equivalent circuit diagram of an operation block according to an embodiment of the disclosed technology;
Fig. 5 is a plan view illustrating ends of a first quantum bit substrate and a second quantum bit substrate according to an embodiment of the disclosed technology;

Fig. 6 is a cross-sectional view taken along a line 6-6 in Fig. 5;

Fig. 7A is a plan view illustrating an example of a configuration of a capacitor according to an embodiment of the disclosed technology;

Fig. 7B is a cross-sectional view illustrating an example of the configuration of the capacitor according to an embodiment of the disclosed technology;

Fig. 8 is a graph illustrating a combined capacitance according to an embodiment of the disclosed technology;

Fig. 9A is a cross-sectional view illustrating an example of a process of manufacturing the first quantum bit substrate according to an embodiment of the disclosed technology;

Fig. 9B is a cross-sectional view illustrating an example of the process of manufacturing the first quantum bit substrate according to the embodiment of the disclosed technology;

Fig. 9C is a cross-sectional view illustrating an example of the process of manufacturing the first quantum bit substrate according to the embodiment of the disclosed technology;

Fig. 9D is a cross-sectional view illustrating an example of the process of manufacturing the first quantum bit substrate according to the embodiment of the disclosed technology;

Fig. 9E is a cross-sectional view illustrating an example of the process of manufacturing the first quantum bit substrate according to the embodiment of the disclosed technology;

Fig. 9F is a cross-sectional view illustrating an example of the process of manufacturing the first quantum bit substrate according to the embodiment of the disclosed technology;

Fig. 9G is a cross-sectional view illustrating an example of the process of manufacturing the first quantum bit substrate according to the embodiment of the disclosed technology;

Fig. 9H is a cross-sectional view illustrating an example of the process of manufacturing the first quantum bit substrate according to the embodiment of the disclosed technology;

Fig. 10A is a cross-sectional view illustrating an example of a manufacturing process of a connection substrate according to an embodiment of the disclosed technology;

Fig. 10B is a cross-sectional view illustrating an example of the manufacturing process of the connection substrate according to the embodiment of the disclosed technology;

Fig. 10C is a cross-sectional view illustrating an example of the manufacturing process of the connection substrate according to the embodiment of the disclosed technology;

Fig. 11A is a view illustrating an example of a step of bonding the first quantum bit substrate and the second quantum bit substrate to the connection substrate according to an embodiment of the disclosed technology;

Fig. 11B is a view illustrating an example of the step of bonding the first quantum bit substrate and the second quantum bit substrate to the connection substrate according to the embodiment of the disclosed technology;

Fig. 12 is a cross-sectional view illustrating an example of a configuration of a quantum bit device according to another embodiment of the disclosed technology;

Fig. 13 is a cross-sectional view illustrating an example of a method for adhering the first quantum bit substrate and the second quantum bit substrate to the connection substrate according to an embodiment of the disclosed technology;

Fig. 14 is a cross-sectional view illustrating an example of a configuration of a quantum bit device according to another embodiment of the disclosed technology;

Fig. 15 is a plan view illustrating ends of a first quantum bit substrate and a second quantum bit substrate according to another embodiment of the disclosed technology; and

Fig. 16 is a cross-sectional view taken along a line 16-16 in Fig. 15.

DESCRIPTION OF EMBODIMENTS

Hereinafter, an example of an embodiment of the disclosed technology will be described with reference to the drawings. In the drawings, the same or equivalent components and portions are denoted by the same reference numerals, and redundant description is omitted.

First Embodiment

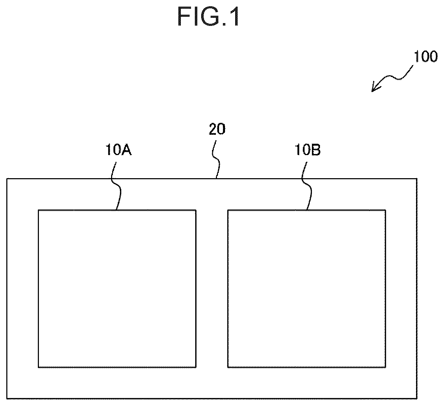

Fig. 1 is a plan view illustrating an example of a configuration of a quantum bit device 100 according to an embodiment of the disclosed technology. The quantum bit device 100 includes a first quantum bit substrate 10A, a second quantum bit substrate 10B, and a connection substrate 20. The first quantum bit substrate 10A and the second quantum bit substrate 10B are mounted on the connection substrate 20. The first quantum bit substrate 10A and the second quantum bit substrate 10B each have a plurality of quantum bits capacitively coupled to each other. Some of the quantum bits provided on the first quantum bit substrate 10A are capacitively coupled to some of the quantum bits provided on the second quantum bit substrate 10B via the connection substrate 20.

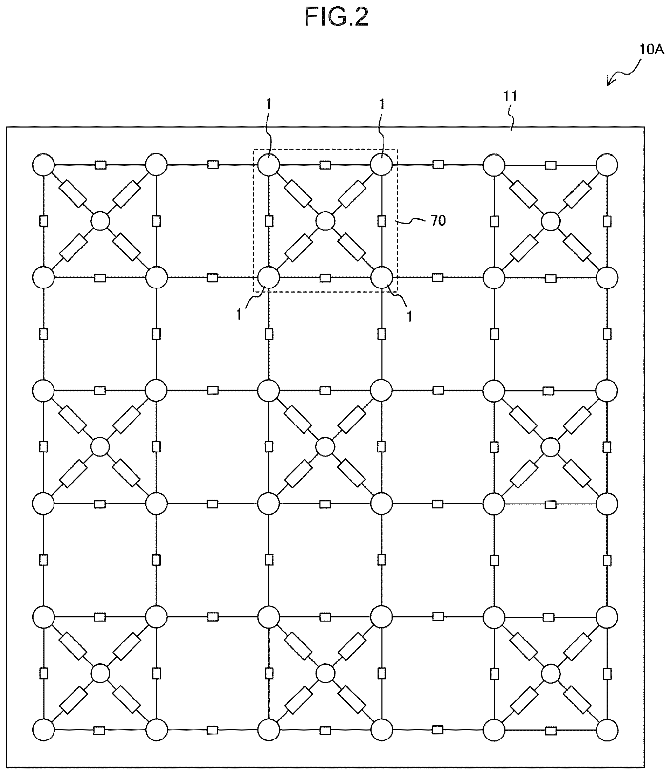

Fig. 2 is a plan view illustrating an example of the configuration of the first quantum bit substrate 10A. The first quantum bit substrate 10A has four quantum bits 1 as a basic unit 70. The first quantum bit substrate 10A has a plurality of basic units 70 arranged in a lattice pattern on a surface of a base material 11 made of, for example, silicon.

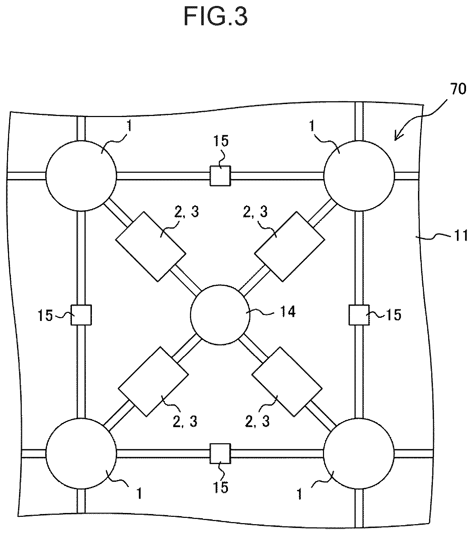

Fig. 3 is an enlarged view of one of the basic units 70 illustrated in Fig. 2. Four quantum bits 1 constituting one basic unit 70 are arranged at positions corresponding to four vertexes of a square, and a reading port 14 is arranged at the center of the square. One reading port 14 is shared by four quantum bits 1. A resonator 2 and a filter 3 are provided on each path from each of the four quantum bits 1 to the reading port 14. Each quantum bit 1 is connected to another adjacent quantum bit 1 via a capacitor 15. As a result, each quantum bit 1 creates a quantum entangled state with another adjacent quantum bit 1 and performs a quantum operation.

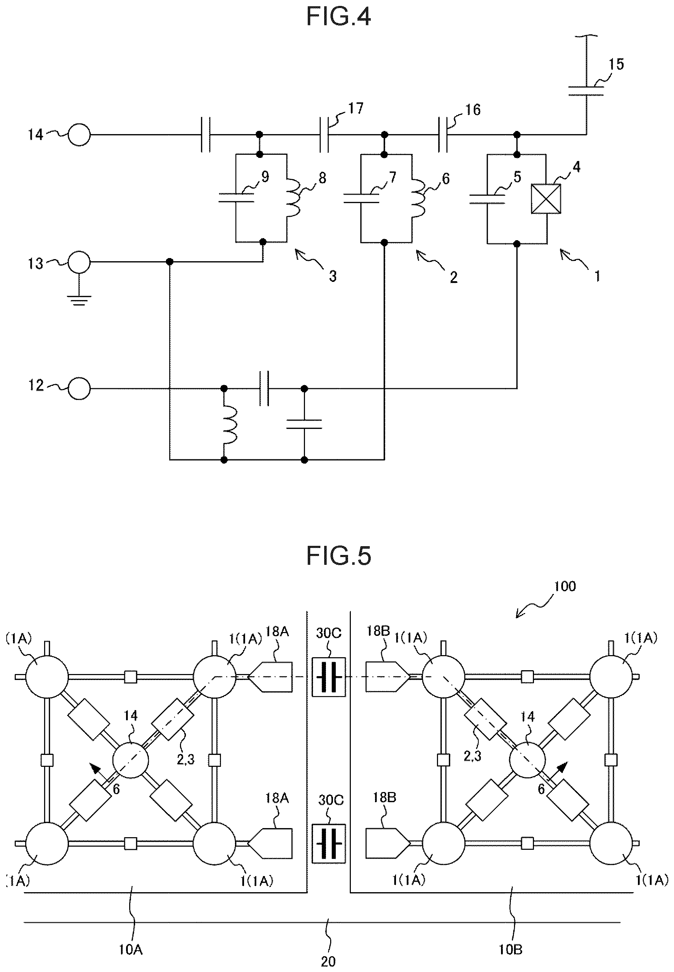

Fig. 4 is an equivalent circuit diagram of an operation block including one quantum bit 1, one resonator 2, and one filter 3. The quantum bit 1 is an element that forms a coherent two-level system using superconductivity and performs a quantum operation using nonlinear energy. The quantum bit 1 has a transmon in which a Josephson element 4 and the capacitor 5 are connected in parallel. The Josephson element 4 includes a pair of superconductor layers that exhibits superconductivity at a temperature equal to or lower than a predetermined critical temperature, and an ultrathin insulator layer having a thickness of about several nm sandwiched between the pair of superconductor layers. The superconductor layer may be, for example, aluminum, and the insulator layer may be, for example, aluminum oxide.

The resonator 2 is connected to the quantum bit 1 via a capacitor 16. The resonator 2 interacts with the quantum bit 1 to read out a response signal indicating the state of the quantum bit 1. The resonator 2 has a resonance circuit in which a superconducting inductor 6 and a capacitor 7 are connected in parallel. The filter 3 is connected to the resonator 2 via a capacitor 17. The filter 3 suppresses relaxation of the signal having the frequency of the quantum bit 1 to the reading port 14. Similarly to the resonator 2, the filter 3 has a resonance circuit in which a superconducting inductor 8 and a capacitor 9 are connected in parallel.

A control port 12, a ground port 13, and the reading port 14 are connected to the operation block. A control signal for controlling the quantum bit 1 is input to the control port 12. In Figs. 2 and 3, illustration of the control port 12 and the ground port 13 is omitted. The state of the quantum bit 1 is controlled by the control signal input to the control port 12. The response signal indicating the state of the quantum bit 1 is read from the reading port 14. The ground port 13 is connected to an external ground potential. The ground potential of the ground port 13 is shared by the ground of each portion of the operation block. Since the configuration of the second quantum bit substrate 10B is the same as that of the first quantum bit substrate 10A, the description thereof will be omitted.

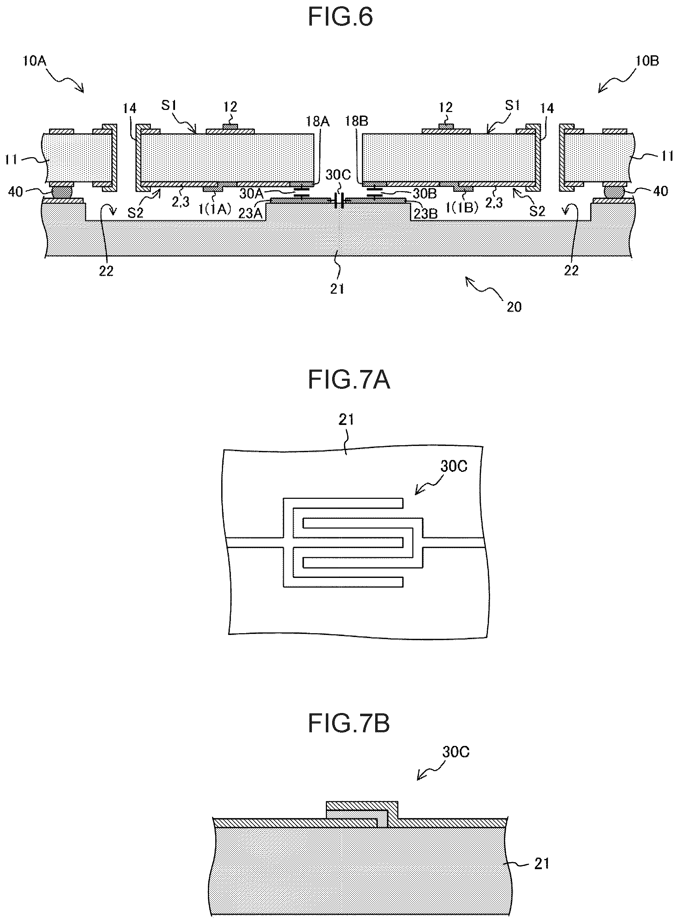

Fig. 5 is a plan view illustrating the ends of the first quantum bit substrate 10A and the second quantum bit substrate 10B, and Fig. 6 is a cross-sectional view taken along a line 6-6 in Fig. 5. The first quantum bit substrate 10A and the second quantum bit substrate 10B have a base material 11 made of, for example, silicon. The control port 12 is provided on a first surface S1 of the base material 11, and a quantum bit 1, a resonator 2, and a filter 3 are provided on a second surface S2 of the base material 11. The quantum bit 1 is provided immediately below the control port 12. A control signal input to the control port 12 acts on the quantum bit 1 via the base material 11. The reading port 14 has a through-electrode structure penetrating the base material 11. The response signal output via the resonator 2 and the filter 3 is transmitted to the first surface S1 of the base material 11 by the reading port 14 of the through-electrode structure.

The first quantum bit substrate 10A has a first electrode 18A connected to the quantum bit 1. Similarly, the second quantum bit substrate 10B has a second electrode 18B connected to the quantum bit 1. The first quantum bit substrate 10A and the second quantum bit substrate 10B are connected to the connection substrate 20 via the bumps 40, and are juxtaposed on the connection substrate 20. The first quantum bit substrate 10A and the second quantum bit substrate 10B are mounted on the connection substrate 20 in a direction in which the second surface S2 on which the quantum bit 1 is formed faces the surface of the connection substrate 20. On the surface of the connection substrate 20, a cavity 22 is provided in a portion corresponding to the quantum bit 1. As a result, it is possible to reduce the risk of forming an unintended coupling with the quantum bit 1.

The connection substrate 20 includes a capacitor 30C at a boundary between the first quantum bit substrate 10A and the second quantum bit substrate 10B. For example, as illustrated in Fig. 7A, the capacitor 30C may be a planar capacitor including, as an electrode, a pair of comb-shaped conductors formed on a surface of a base material 21 of the connection substrate 20. Furthermore, as illustrated in Fig. 7B, the capacitor 30C may be a laminated capacitor having a metal/insulator/metal (MIM) structure formed on the surface of the base material 21. The connection substrate 20 includes a third electrode 23A connected to one electrode of the capacitor 30C and a fourth electrode 23B connected to the other electrode of the capacitor 30C. The capacitor 30C is an example of the "third capacitor" in the disclosed technology.

The first quantum bit substrate 10A is mounted on the connection substrate 20 such that the first electrode 18A and the third electrode 23A face each other and a gap is formed between these electrodes. Similarly, the second quantum bit substrate 10B is mounted on the connection substrate 20 such that the second electrode 18B and the fourth electrode 23B face each other and a gap is formed between these electrodes.

By mounting the first quantum bit substrate 10A and the second quantum bit substrate 10B on the connection substrate 20, capacitive coupling by the capacitors 30A, 30B, and 30C connected in series is formed between a quantum bit 1A provided at the end of the first quantum bit substrate 10A and a quantum bit 1B provided at the end of the second quantum bit substrate 10B. That is, the capacitors 30A, 30B, and 30C are provided in series between the quantum bit 1A provided on the first quantum bit substrate 10A and the quantum bit 1B provided on the second quantum bit substrate 10B.

The capacitor 30A includes a first electrode 18A provided on the first quantum bit substrate 10A and a third electrode 23A provided on the connection substrate 20. The capacitor 30A has a structure in which a gap is interposed between the first electrode 18A and the third electrode 23A. The capacitor 30A is an example of the "first capacitor" in the disclosed technology. The capacitor 30B includes a second electrode 18B provided on the second quantum bit substrate 10B and a fourth electrode 23B provided on the connection substrate 20. The capacitor 30B has a structure in which a gap is interposed between the second electrode 18B and the fourth electrode 23B. The capacitor 30B is an example of the "second capacitor" in the disclosed technology.

A combined capacitance $C_X$ between the quantum bit 1A provided on the first quantum bit substrate 10A and the quantum bit 1B provided on the second quantum bit substrate 10B is expressed by the following Formula (2). In Formula (2), $C_A$ is the capacitance of the capacitor 30A, $C_B$ is the capacitance of the capacitor 30B, and $C_C$ is the capacitance of the capacitor 30C.

$$1/C_X = 1/C_A + 1/C_B + 1/C_C \ ...(2)$$

Since the capacitor 30C is formed in a single plane or on a single plane, it is possible to form the capacitor with high processing accuracy using existing microfabrication techniques such as photolithography and etching. Therefore, the electrode area S and the inter-electrode distance d of the capacitor 30C do not greatly vary. Therefore, the variation in the capacitance $C_C$ of the capacitor 30C can be reduced. On the other hand, the capacitor 30A is an inter-substrate capacitor formed between the first quantum bit substrate 10A and the connection substrate 20. For this reason, since the electrode area S varies due to misalignment when the first quantum bit substrate 10A is mounted on the connection substrate 20, and the inter-electrode distance d varies due to a difference in deformation of the bump 40, the capacitance $C_A$ tends to vary more greatly than the capacitance $C_C$. The same applies to the capacitor 30B.

In the quantum bit device 100 according to the present embodiment, each of the capacitance $C_A$ of the capacitor 30A and the capacitance $C_B$ of the capacitor 30B is significantly larger than the capacitance $C_C$ of the capacitor 30C. That is, the relationship among the capacitances $C_A$, $C_B$, and $C_C$ is expressed by the following Formula (3).

$$C_A \approx C_B \gg C_C \ ...(3)$$

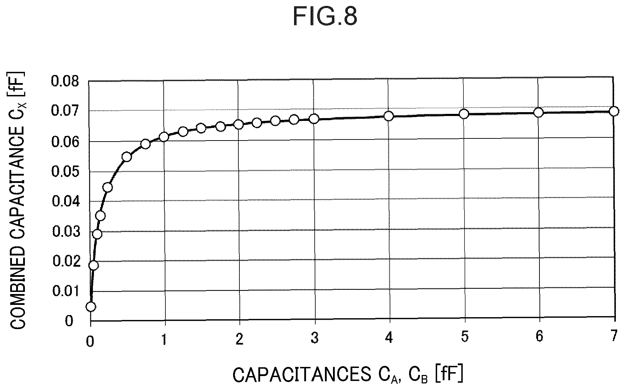

When the relationship among the capacitances $C_A$, $C_B$, and $C_C$ satisfies the above Formula (3), the influence of the variation in the capacitances $C_A$ and $C_B$ in the combined capacitance $C_X$ can be reduced. Fig. 8 is a graph illustrating the combined capacitance $C_X$ when the capacitances $C_A$ and $C_B$ ($C_A=C_B$) are changed in a case where the capacitance $C_C$ is fixed to 0.07 [fF]. As the capacitances $C_A$ and $C_B$ increase, the combined capacitance $C_X$ converges to 0.07 [fF]. This means that the influence of the variation in the capacitances $C_A$ and $C_B$ in the combined capacitance $C_X$ decreases as the deviations of the capacitances $C_A$ and $C_B$ from the capacitance $C_C$ increase. In order to substantially eliminate the influence of the variation in the capacitances $C_A$ and $C_B$, the capacitances $C_A$ and $C_B$ are preferably 10 times or more, and more preferably 40 times or more the capacitance $C_C$.

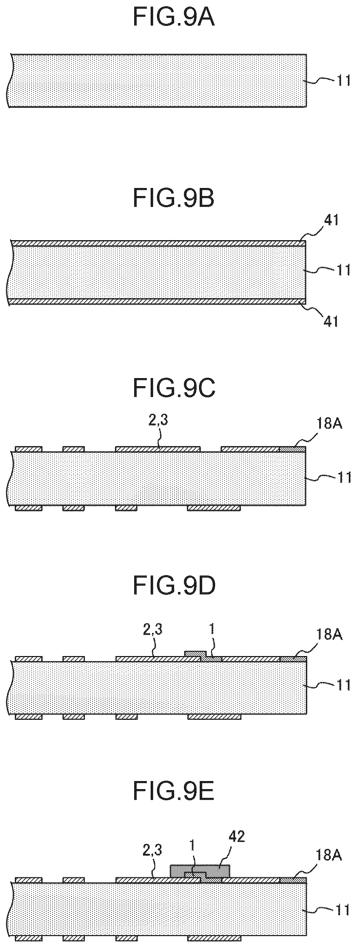

Hereinafter, a method of manufacturing the quantum bit device 100 will be described. Figs. 9A to 9H are cross-sectional views illustrating an example of a process of manufacturing the first quantum bit substrate 10A. Since the method of manufacturing the second quantum bit substrate 10B is the same as that of the first quantum bit substrate 10A, the description thereof will be omitted.

First, the base material 11 of the first quantum bit substrate 10A is prepared. As the base material 11, for example, a silicon substrate having a thickness of about 300 $\mu$m can be used (Fig. 9A). Next, a conductive film 41 having a thickness of about 100 nm is formed on both surfaces of the base material 11 using, for example, a sputtering method, plasma chemical vapor deposition (CVD), or an ion plating method. For example, TiN can be used as the material of the conductive film 41 (Fig. 9B). Next, a resist mask (not illustrated) is formed on the surface of the conductive film 41, and the conductive film 41 is patterned by partially etching the conductive film 41 through the resist mask. As a result, the resonator 2, the filter 3, the first electrode 18A, and the like are formed (Fig. 9C).

Next, a quantum bit 1 is formed on the surface of the base material 11 (Fig. 9D). The superconducting Josephson element constituting the quantum bit 1 is formed through, for example, a step of forming a lower electrode (not illustrated) containing Al on the surface of the base material 11 by a vapor deposition method, a step of forming an extremely thin oxide film (not illustrated) having a thickness of about several nm on the surface of the lower electrode using an $O_2$ gas, and a step of forming an upper electrode (not illustrated) containing Al on the surface of the oxide film by a vapor deposition method. The lower electrode and the upper electrode may be patterned by, for example, a lift-off method using a patterned resist mask (not illustrated). In this case, the opening pattern of the resist mask may have a cross shape having a first linear portion along a first direction and a second linear portion along a second direction orthogonal to the first direction, and the lower electrode may be formed in a portion corresponding to the first linear portion by performing vapor deposition while inclining the resist mask about the first direction as a rotation axis. Subsequently, the upper electrode may be formed in a portion corresponding to the second linear portion by performing vapor deposition while inclining the resist mask about the second direction as the rotation axis. According to the above method, the lower electrode and the upper electrode can be patterned by a single resist mask.

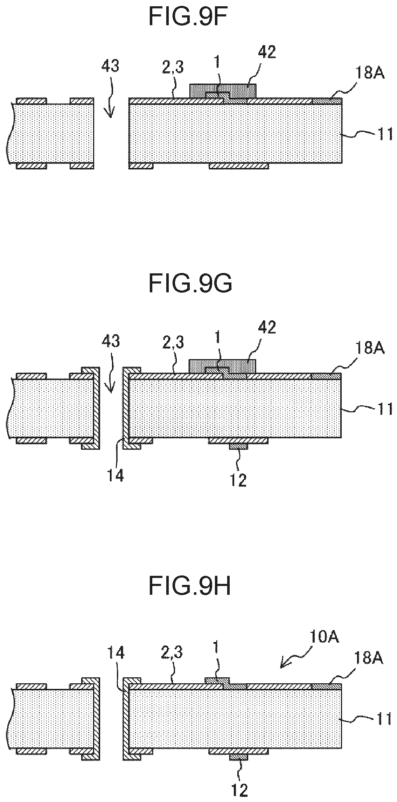

Next, a protective film 42 covering the surface of the quantum bit 1 is formed by, for example, a CVD method. For example, $SiO_2$ can be used as the material of the protective film 42. Thereafter, the protective film 42 is patterned using a photolithography technique (Fig. 9E). Next, a hard mask (not illustrated) having an opening at the formation position of the reading port 14 is formed, and a through hole 43 is formed at the formation position of the reading port 14 of the base material 11 by, for example, a deep-reactive ion etching (RIE) method using the hard mask (Fig. 9F). Next, a conductive film that covers the inner wall of the through hole 43 and the periphery of the opening end of the through hole 43 is formed by, for example, a vapor deposition method. For example, Al can be used as the material of the conductive film. Thereafter, the conductive film is patterned by, for example, a lift-off method. As a result, the control port 12 and the reading port 14 are formed (Fig. 9G). Next, the protective film 42 covering the quantum bit 1 is removed by etching using, for example, vapor hydrofluoric acid (Fig. 9H). Through the above steps, the first quantum bit substrate 10A is completed. The second quantum bit substrate 10B is also manufactured in a similar process.

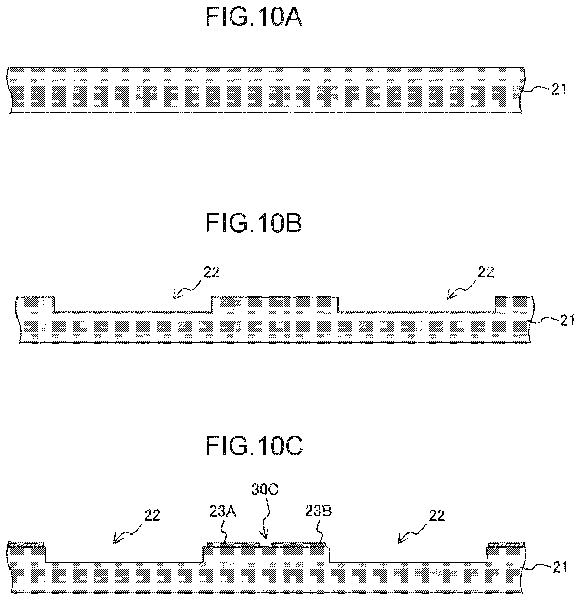

Figs. 10A to 10C are cross-sectional views illustrating an example of a manufacturing process of the connection substrate 20. First, the base material 21 of the connection substrate 20 is prepared. As the base material 21, for example, a silicon substrate having a thickness of about 300 $\mu$m can be used (Fig. 10A).

Next, a resist mask (not illustrated) is formed on the surface of the base material 21, and the surface of the base material 21 is partially etched through the resist mask to form a cavity 22 at a predetermined position on the surface of the base material 21 (Fig. 10B). A Deep-RIE method can be used as an etching method.

Next, a resist mask (not illustrated) patterned to correspond to the patterns of the third electrode 23A, the fourth electrode 23B, and the capacitor 30C is formed on the surface of the base material 21. Next, a conductive film such as an Al film is formed on the surface of the base material 21 through the resist mask by a vapor deposition method. Next, the conductive film on the resist mask is removed together with the resist mask to pattern the conductive film. As a result, the third electrode 23A, the fourth electrode 23B, and the capacitor 30C are formed on the surface of the base material 21 (Fig. 10C).

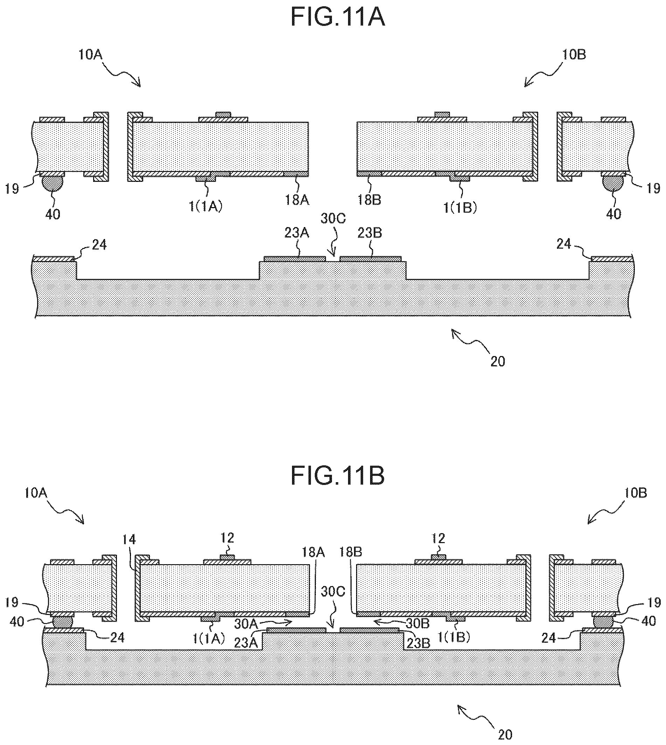

Figs. 11A and 11B are diagrams illustrating an example of a process of bonding the first quantum bit substrate 10A and the second quantum bit substrate 10B to the connection substrate 20. The bump 40 is formed on the surface of a connection electrode 19 formed on the second surface S2 of each of the first quantum bit substrate 10A and the second quantum bit substrate 10B. For example, In can be used as the material of the bump 40.

Next, the connection electrode 19 of each of the first quantum bit substrate 10A and the second quantum bit substrate 10B and the connection electrode 24 of the connection substrate 20 are bonded via the bump 40. As a result, the first quantum bit substrate 10A and the second quantum bit substrate 10B are bonded to the connection substrate 20. In this state, the first electrode 18A and the third electrode 23A face each other with a gap therebetween, and the second electrode 18B and the fourth electrode 23B face each other with a gap therebetween. The first electrode 18A and the third electrode 23A form the capacitor 30A. The second electrode 18B and the fourth electrode 23B form the capacitor 30B. Then, capacitive coupling by the capacitors 30A, 30B, and 30C connected in series is formed between the quantum bit 1A provided on the first quantum bit substrate 10A and the quantum bit 1B provided on the second quantum bit substrate 10B.

As described above, according to the quantum bit device 100 according to the embodiment of the disclosed technology, it is possible to form capacitive coupling by the capacitors 30A, 30B, and 30C connected in series between the quantum bits provided on two quantum bit substrates different from each other. As a result, as compared with a case where the capacitive coupling between the quantum bits is formed only in a single quantum bit substrate, the number of formable two-qubit gates can be increased, so that the quantum operation processing capability can be increased.

The capacitances $C_A$ and $C_B$ of the capacitors 30A and 30B formed between each of the first quantum bit substrate 10A and the second quantum bit substrate 10B and the connection substrate 20 have relatively large variations. However, since the capacitances $C_A$ and $C_B$ are significantly larger than the capacitance $C_C$ of the capacitor 30C having a relatively small variation, the influence of the variation in the capacitances $C_A$ and $C_B$ in the combined capacitance $C_X$ can be reduced. That is, according to the quantum bit device 100 according to the embodiment of the disclosed technology, in the configuration in which the quantum bits provided in each of the plurality of quantum bit substrates are capacitively coupled via the connection substrate, it is possible to suppress the variation in coupling strength between the quantum bits.

In the above description, the configuration in which the quantum bit device has two quantum bit substrates has been exemplified, but the quantum bit device may have three or more quantum bits mounted on the connection substrate. Also in this case, in each pair of two quantum bit substrates adjacent to each other, capacitive coupling is formed by the capacitors 30A, 30B, and 30C connected in series between the quantum bits, and capacitance of these capacitors is configured to satisfy $C_A \approx C_B >> C_C$.

Second Embodiment

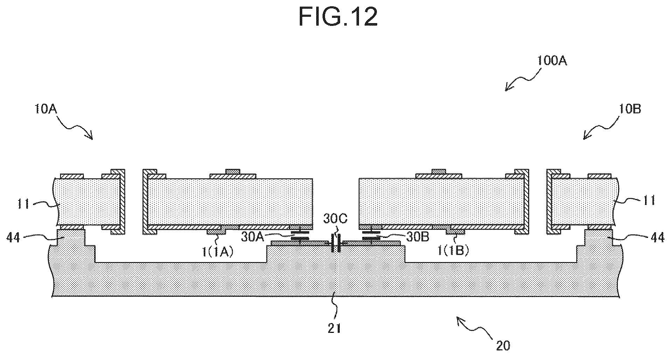

Fig. 12 is a cross-sectional view illustrating an example of a configuration of a quantum bit device 100A according to a second embodiment of the disclosed technology. The quantum bit device 100A has a spacer 44 for forming a gap between the first quantum bit substrate 10A and the second quantum bit substrate 10B and the connection substrate 20. The spacer 44 may have a protruding structure formed in a contact portion with each quantum bit substrate by etching the base material 21 of the connection substrate 20, for example. The spacer 44 may be formed of a member other than the base material 21 (for example, metal).

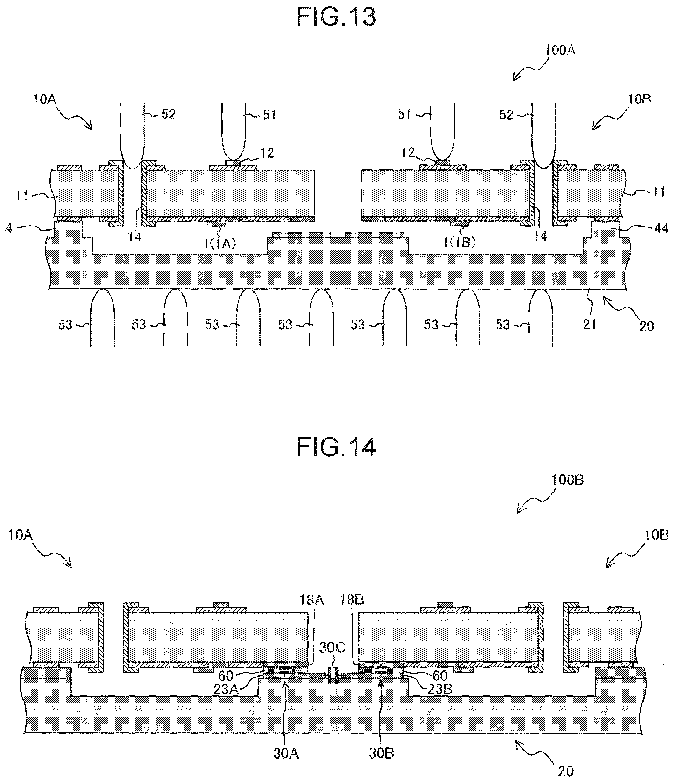

In order to bring the first quantum bit substrate 10A and the second quantum bit substrate 10B into close contact with the connection substrate 20 via the spacer 44, for example, as illustrated in Fig. 13, a pressing force applied via various probes used at the time of operation of the quantum bit device 100A may be used. A control probe 51 is a probe for inputting a control signal to the quantum bit 1, and is brought into contact with the control port 12. A reading probe 52 is a probe for reading a response signal indicating the state of the quantum bit 1, and is brought into contact with the reading port 14. A ground probe 53 is a probe for applying a ground potential to the connection substrate 20, and is in contact with the back surface of the connection substrate 20. A pressing force for pressing the first quantum bit substrate 10A and the second quantum bit substrate 10B against the connection substrate 20 is applied via the control probe 51 and the reading probe 52. A pressing force for pressing the connection substrate 20 against the first quantum bit substrate 10A and the second quantum bit substrate 10B is applied by the ground probe 53. These probes have a plunger, a pipe, and a spring (none of which are illustrated), and are configured such that the plunger connected to the spring strokes along the inner wall of the pipe to stabilize the pressing force.

Since the first quantum bit substrate 10A and the second quantum bit substrate 10B are not bonded to the connection substrate 20, when any of the quantum bit substrates is deteriorated, damaged, or failed, the quantum bit substrate can be easily replaced.

Third Embodiment

Fig. 14 is a cross-sectional view illustrating an example of a configuration of a quantum bit device 100B according to a third embodiment of the disclosed technology. In the quantum bit device 100B, the capacitors 30A and 30B each have an insulator 60. That is, the capacitor 30A has a structure in which the insulator 60 is sandwiched between the first electrode 18A and the third electrode 23A. The capacitor 30B has a structure in which the insulator 60 is sandwiched between the second electrode 18A and the fourth electrode 23B. The insulator 60 may be provided on the surface of the first electrode 18A and the surface of the second electrode 18B, or may be provided on the surface of the third electrode 23A and the surface of the fourth electrode 23B. Furthermore, the insulator 60 may be provided on the surface of each of the first to fourth electrodes.

By providing the insulator 60 between the electrodes of the capacitors 30A and 30B, a spacer for forming a gap between the first quantum bit substrate 10A and the second quantum bit substrate 10B and the connection substrate 20 becomes unnecessary. This simplifies the structure, so that the yield of the device can be improved.

Fourth Embodiment

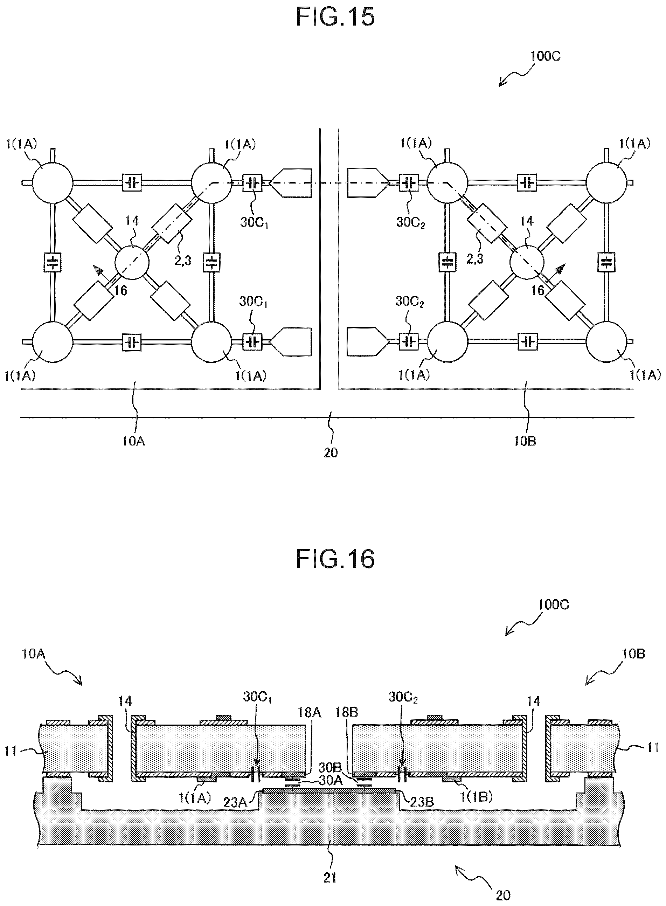

Fig. 15 is a plan view illustrating the ends of the first quantum bit substrate 10A and the second quantum bit substrate 10B according to the fourth embodiment of the disclosed technology, and Fig. 16 is a cross-sectional view taken along a line 16-16 in Fig. 15. In the quantum bit devices 100, 100A, and 100B according to the first to third embodiments described above, the capacitor 30C having a relatively small variation in capacitance is provided on the connection substrate 20. On the other hand, in the quantum bit device 100C according to the fourth embodiment, capacitors $30C_1$ and $30C_2$ corresponding to the capacitors 30C are provided on the first quantum bit substrate 10A and the second quantum bit substrate 10B, respectively.

Each of the capacitors $30C_1$ and $30C_2$ may be a planar capacitor having a pair of comb-shaped conductors formed on the surface of the base material 11 of each quantum bit substrate as an electrode, or may be a laminated capacitor having an MIM structure formed on the surface of the base material 11.

In the capacitor $30C_1$, one electrode is connected to the quantum bit 1A, and the other electrode is connected to the first electrode 18A. In the capacitor $30C_2$, one electrode is connected to the quantum bit 1B, and the other electrode is connected to the second electrode 18B. By mounting the first quantum bit substrate 10A and the second quantum bit substrate 10B on the connection substrate 20, capacitive coupling by the capacitors $30C_1$, 30A, 30B, and $30C_2$ connected in series is formed between the quantum bit 1A and the quantum bit 1B.

The combined capacitance $C_X$ between the quantum bit 1A and the quantum bit 1B is expressed by the following Formula (4). In Formula (4), $C_A$ is the capacitance of capacitor 30A, $C_B$ is the capacitance of capacitor 30B, $C_{C1}$ is the capacitance of capacitor $30C_1$, and $C_{C2}$ is the capacitance of capacitor $30C_2$.

$$1/C_X = 1/C_A + 1/C_B + 1/C_{C1} + 1/C_{C2} \text{ ...(4)}$$

Since each of the capacitors $30C_1$ and $30C_2$ is formed in a single plane or on a single plane, it is possible to form the capacitors with high processing accuracy using existing microfabrication techniques such as photolithography and etching. Therefore, the electrode areas S and the inter-electrode distances d of the capacitors $30C_1$ and $30C_2$ do not greatly vary. Therefore, variations in the capacitances $C_{C1}$ and $C_{C2}$ of the capacitors $30C_1$ and $30C_2$ can be reduced. On the other hand, the capacitor 30A is an inter-substrate capacitor formed between the first quantum bit substrate 10A and the connection substrate 20. For this reason, since the electrode area S varies due to misalignment when the first quantum bit substrate 10A is mounted on the connection substrate 20, and the inter-electrode distance d varies due to a difference in deformation of the bump 40, the capacitance $C_A$ tends to vary more greatly than the capacitances $C_{C1}$ and $C_{C2}$. The same applies to the capacitor 30B.

In the quantum bit device 100C according to the present embodiment, the capacitance $C_A$ of the capacitor 30A and the capacitance $C_B$ of the capacitor 30B are significantly larger than the capacitances $C_{C1}$ and $C_{C2}$ of the capacitors $30C_1$ and $30C_2$, respectively. That is, the relationship between the capacitances $C_A$, $C_B$ and $C_{C1}$ and $C_{C2}$ is expressed by the following Formula (5).

$$C_A \approx C_B >> C_{C1} \approx C_{C2} \text{ ...(5)}$$

When the relationship among the capacitances $C_A$, $C_B$, $C_{C1}$, and $C_{C2}$ satisfies the above Formula (5), the influence of the variation in the capacitances $C_A$ and $C_B$ in the combined capacitance $C_X$ can be reduced.

According to the quantum bit device 100C of the present embodiment, similarly to the quantum bit device of the first to third embodiments, in the configuration in which the quantum bits provided in each of the plurality of quantum bit substrates are capacitively coupled via the connection substrate, it is possible to suppress the variation in coupling strength between the quantum bits.

According to the disclosed technology, in a quantum bit device in which quantum bits provided on each of a plurality of quantum bit substrates are capacitively coupled via a connection substrate, it is possible to suppress variations in coupling strength between the quantum bits.

With regard to the first to fourth embodiments described above, the following supplementary notes are further disclosed.

(Supplement 1)

A quantum bit device including:

a first quantum bit substrate having a first quantum bit and a first electrode;
a second quantum bit substrate having a second quantum bit and a second electrode;
a connection substrate having a third electrode and a fourth electrode and provided to face the first quantum bit substrate and the second quantum bit substrate;
a first capacitor including the first electrode and the third electrode;
a second capacitor including the second electrode and the fourth electrode; and third capacitors;
in which the first capacitor, the second capacitor, and the third capacitors are provided in series between the first quantum bit and the second quantum bit, and a capacitance of the first capacitor and a capacitance of the second capacitor are each larger than a capacitance of the third capacitor.

(Supplement 2)

The quantum bit device according to Supplement 1, in which the third capacitors are provided on the connection substrate.

(Supplement 3)

The quantum bit device according to Supplement 1, in which the third capacitors are provided on at least one of the first quantum bit substrate and the second quantum bit substrate.

(Supplement 4)

The quantum bit device according to any one of Supplement 1 to 3, in which

the first capacitor has a structure in which a gap formed between the first quantum bit substrate and the connection substrate is interposed between the first electrode and the third electrode, and
the second capacitor has a structure in which a gap formed between the second quantum bit substrate and the connection substrate is interposed between the second electrode and the fourth electrode.

(Supplement 5)

The quantum bit device according to Supplement 4, further including a spacer for forming a gap provided between the first quantum bit substrate and the connection substrate and between the second quantum bit substrate and the connection substrate.

(Supplement 6)

The quantum bit device according to any one of Supplement 1 to 3, in which

the first capacitor has a structure in which an insulator provided between the first quantum bit substrate and the connection substrate is sandwiched between the first electrode and the third electrode, and

the second capacitor has a structure in which an insulator provided between the second quantum bit substrate and the connection substrate is sandwiched between the second electrode and the fourth electrode.

(Supplement 7)

The quantum bit device according to any one of Supplement 1 to 6, in which the third capacitors are planar capacitors having a pair of electrodes formed in a single plane.

(Supplement 8)

The quantum bit device according to any one of Supplement 1 to 6, in which the third capacitors have a metal/insulator/metal (MIM) structure formed on a single plane.

(Supplement 9)

The quantum bit device according to any one of Supplement 1 to 8, in which a capacitance of the first capacitor and a capacitance of the second capacitor are 10 times or more a capacitance of the third capacitors.

(Supplement 10)

The quantum bit device according to Supplement 2, in which the third capacitors are provided at a position corresponding to a boundary between the first quantum bit substrate and the second quantum bit substrate on the connection substrate.

(Supplement 11)

The quantum bit device according to Supplement 3, in which

one of the third capacitors is provided between the first quantum bit of the first quantum bit substrate and the first electrode, and
another one of the third capacitors is provided between the second quantum bit of the second quantum bit substrate and the second electrode.

(Supplement 12)

A method of manufacturing a quantum bit device includes:

forming a first quantum bit substrate having a first quantum bit and a first electrode;
forming a second quantum bit substrate having a second quantum bit and a second electrode;
forming a connection substrate having a third electrode and a fourth electrode; and
disposing the first quantum bit substrate, the second quantum bit substrate, and the connection substrate such that each of the first quantum bit substrate and the second quantum bit substrate faces the connection substrate,
in which a first capacitor including the first electrode and the third electrode and a second capacitor including the second electrode and the fourth electrode are formed, and the first capacitor, the second capacitor, and the third capacitors are provided in series between the first quantum bit and the second quantum bit, and
a capacitance of the first capacitor and a capacitance of the second capacitor are larger than a capacitance of the third capacitors.

(Supplement 13)

The method of manufacturing according to Supplement 12, in which the third capacitors are provided on the connection substrate.

(Supplement 14)

The method of manufacturing according to Supplement 12, in which the third capacitors are provided on at least one of the first quantum bit substrate and the second quantum bit substrate.

(Supplement 15)

The method of manufacturing according to any one of Supplement 12 to 14, in which

the first capacitor has a structure in which a gap formed between the first quantum bit substrate and the connection substrate is interposed between the first electrode and the third electrode, and
the second capacitor has a structure in which a gap formed between the second quantum bit substrate and the connection substrate is interposed between the second electrode and the fourth electrode.

(Supplement 16)

The method of manufacturing according to Supplement 15, further including a spacer for forming a gap provided between the first quantum bit substrate and the connection substrate and between the second quantum bit substrate and the connection substrate.

(Supplement 17)

The method of manufacturing according to any one of Supplement 12 to 14, in which

the first capacitor has a structure in which an insulator provided between the first quantum bit substrate and the connection substrate is sandwiched between the first electrode and the third electrode, and

the second capacitor has a structure in which an insulator provided between the second quantum bit substrate and the connection substrate is sandwiched between the second electrode and the fourth electrode.

(Supplement 18)

The method of manufacturing according to any one of Supplement 12 to 17, in which the third capacitors are planar capacitors having a pair of electrodes formed in a single plane.

(Supplement 19)

The method of manufacturing according to any one of Supplement 12 to 17, in which the third capacitors have a metal/insulator/metal (MIM) structure formed on a single plane.

(Supplement 20)

The method of manufacturing according to any one of Supplement 12 to 19, in which a capacitance of the first capacitor and a capacitance of the second capacitor are 10 times or more a capacitance of the third capacitors.

**Claims**

1. A quantum bit device including:

a first quantum bit substrate having a first quantum bit and a first electrode;
a second quantum bit substrate having a second quantum bit and a second electrode;
a connection substrate having a third electrode and a fourth electrode and provided to face the first quantum bit substrate and the second quantum bit substrate;
a first capacitor including the first electrode and the third electrode;
a second capacitor including the second electrode and the fourth electrode; and
third capacitors;
in which the first capacitor, the second capacitor, and the third capacitors are provided in series between the first quantum bit and the second quantum bit, and
a capacitance of the first capacitor and a capacitance of the second capacitor are each larger than a capacitance of the third capacitor.

2. The quantum bit device according to claim 1, in which the third capacitors are provided on the connection substrate.

3. The quantum bit device according to claim 1, in which the third capacitors are provided on at least one of the first quantum bit substrate and the second quantum bit substrate.

4. The quantum bit device according to any one of claims 1 to 3, in which

the first capacitor has a structure in which a gap formed between the first quantum bit substrate and the connection substrate is interposed between the first electrode and the third electrode, and
the second capacitor has a structure in which a gap formed between the second quantum bit substrate and the connection substrate is interposed between the second electrode and the fourth electrode.

5. The quantum bit device according to claim 4, further including a spacer for forming a gap provided between the first quantum bit substrate and the connection substrate and between the second quantum bit substrate and the connection substrate.

6. The quantum bit device according to any one of claims 1 to 3, in which

the first capacitor has a structure in which an insulator provided between the first quantum bit substrate and the connection substrate is sandwiched between the first electrode and the third electrode, and
the second capacitor has a structure in which an insulator provided between the second quantum bit substrate and the connection substrate is sandwiched between the second electrode and the fourth electrode.

7. The quantum bit device according to any one of claims 1 to 6, in which the third capacitors are planar capacitors having a pair of electrodes formed in a single plane.

8. The quantum bit device according to any one of claims 1 to 6, in which the third capacitors have a metal/insulator/metal (MIM) structure formed on a single plane.

9. The quantum bit device according to any one of claims 1 to 8, in which a capacitance of the first capacitor and a capacitance of the second capacitor are 10 times or more a capacitance of the third capacitors.

10. The quantum bit device according to claim 3, in which

one of the third capacitors is provided between the first quantum bit of the first quantum bit substrate and the first electrode, and another one of the third capacitors is provided between the second quantum bit of the second quantum bit substrate and the second electrode.

11. A method of manufacturing a quantum bit device includes:

forming a first quantum bit substrate having a first quantum bit and a first electrode; forming a second quantum bit substrate having a second quantum bit and a second electrode; forming a connection substrate having a third electrode and a fourth electrode; and disposing the first quantum bit substrate, the second quantum bit substrate, and the connection substrate such that each of the first quantum bit substrate and the second quantum bit substrate faces the connection substrate, in which a first capacitor including the first electrode and the third electrode and a second capacitor including the second electrode and the fourth electrode are formed, and the first capacitor, the second capacitor, and the third capacitors are provided in series between the first quantum bit and the second quantum bit, and a capacitance of the first capacitor and a capacitance of the second capacitor are larger than a capacitance of the third capacitors.

12. The method of manufacturing according to claim 11, in which the third capacitors are provided on the connection substrate.

13. The method of manufacturing according to claim 11, in which the third capacitors are provided on at least one of the first quantum bit substrate and the second quantum bit substrate.

14. The method of manufacturing according to any one of claims 11 to 13, in which

the first capacitor has a structure in which a gap formed between the first quantum bit substrate and the connection substrate is interposed between the first electrode and the third electrode, and the second capacitor has a structure in which a gap formed between the second quantum bit substrate and the connection substrate is interposed between the second electrode and the fourth electrode.

15. The method of manufacturing according to any one of claims 11 to 13, in which

the first capacitor has a structure in which an insulator provided between the first quantum bit substrate and the connection substrate is sandwiched between the first electrode and the third electrode, and the second capacitor has a structure in which an insulator provided between the second quantum bit substrate and the connection substrate is sandwiched between the second electrode and the fourth electrode.

FIG.1

100

10A  20  10B

# FIG.2

FIG.3

# FIG.4

# FIG.5

# FIG.6

# FIG.7A

# FIG.7B

# FIG.8

# FIG.9A

11

# FIG.9B

41

11

41

# FIG.9C

2,3

18A

11

# FIG.9D

2,3

1

18A

11

# FIG.9E

2,3

1

42

18A

11

## FIG.9F

## FIG.9G

## FIG.9H

FIG.10A

~21

FIG.10B

22

22

~21

FIG.10C

30C

23A    23B

22

22

~21

# FIG.11A

# FIG.11B

# FIG.12

# FIG.13

# FIG.14

# FIG.15

# FIG.16

Europäisches
Patentamt

European
Patent Office

Office européen
des brevets

# EUROPEAN SEARCH REPORT

**Application Number**

EP 25 19 7749

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | LIANG G-H ET AL: "Tunable Coupling Architectures with Capacitively Connecting Pads for Large-Scale Superconducting Multi-Qubit Processors", ARXIV.ORG, CORNELL UNIVERSITY LIBRARY, 201 OLIN LIBRARY CORNELL UNIVERSITY ITHACA, NY 14853, 8 June 2023 (2023-06-08), XP091533451, * page 1 - page 7; figures 1, 2, 6 * | 1-15 | INV. H10N69/00 |
| A | GOLD A ET AL: "Entanglement across separate silicon dies in a modular superconducting qubit device", NPJ QUANTUM INFORMATION, vol. 7, 142, 28 September 2021 (2021-09-28), XP093337252, DOI: 10.1038/s41534-021-00484-1 Retrieved from the Internet: URL:https://www.nature.com/articles/s41534-021-00484-1.pdf> * page 1 - page 2; figure 1 * | 1-15 | |
| A | US 2023/394345 A1 (MCKAY D C [US]) 7 December 2023 (2023-12-07) * paragraph [0090] - paragraph [0097]; figures 2, 4, 5 * | 1-15 | TECHNICAL FIELDS SEARCHED (IPC)  H10N |

-/--

The present search report has been drawn up for all claims

| Place of search | Date of completion of the search | Examiner |
|---|---|---|
| Munich | 26 January 2026 | Carmiggelt, Joris |

page 1 of 2

Europäisches
Patentamt

European
Patent Office

Office européen
des brevets

# EUROPEAN SEARCH REPORT

**Application Number**

EP 25 19 7749

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | FIELD M ET AL: "Modular superconducting-qubit architecture with a multichip tunable coupler", PHYSICAL REVIEW APPLIED, vol. 21, no. 5, 9 April 2024 (2024-04-09), XP093275334, ISSN: 2331-7019, DOI: 10.1103/PhysRevApplied.21.054063 Retrieved from the Internet: URL:https://journals.aps.org/prapplied/pdf/10.1103/PhysRevApplied.21.054063> * page 1 - page 5; figures 1-3 * | 1-15 | |
| A | WU X ET AL: "Modular quantum processor with an all-to-all reconfigurable router", ARXIV.ORG, CORNELL UNIVERSITY LIBRARY, 201 OLIN LIBRARY CORNELL UNIVERSITY ITHACA, NY 14853, 29 July 2024 (2024-07-29), XP091834296, * page 1 - page 13; figures 1, 6, 8, 10 * | 1-15 | **TECHNICAL FIELDS SEARCHED (IPC)** |

The present search report has been drawn up for all claims

| Place of search | Date of completion of the search | Examiner |
|---|---|---|
| Munich | 26 January 2026 | Carmiggelt, Joris |

EPO FORM 1503 03.82 (P04C01)

## ANNEX TO THE EUROPEAN SEARCH REPORT
## ON EUROPEAN PATENT APPLICATION NO.

EP 25 19 7749

This annex lists the patent family members relating to the patent documents cited in the above-mentioned European search report.
The members are as contained in the European Patent Office EDP file on
The European Patent Office is in no way liable for these particulars which are merely given for the purpose of information.

26-01-2026

| Patent document cited in search report | Publication date | Patent family member(s) | Publication date |
|---|---|---|---|
| US 2023394345 A1 | 07-12-2023 | NONE | |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2018212041 A
- JP 2023069792 A